# EUROPEAN PATENT APPLICATION

(11) **EP 2 544 223 A1**
(43) Date of publication of application: **09.01.2013**
(21) Application number: 11750333.4
(22) Date of filing: 21.02.2011
(51) Int. Cl.: H01L 21/205, C23C 16/509, H05H 1/46

(54) **THIN FILM FORMING APPARATUS**

(30) Priority: 03.03.2010 JP 2010046846
(71) Applicant: Mitsui Engineering & Shipbuilding Co., Ltd., Chuo-ku Tokyo 104-8439 (JP)
(72) Inventor: TAKIZAWA, Kazuki, Tamano-shi Okayama 706-8651 (JP); MIYATAKE, Naomasa, Tamano-shi Okayama 706-8651 (JP); MURATA, Kazutoshi, Tamano-shi Okayama 706-8651 (JP)
(74) Representative: Hards, Andrew
(86) International application number: PCT/JP2011/000957
(87) International publication number: WO 2011/108219

(57) **Abstract**

The thin-film forming apparatus includes: a deposition vessel that includes a deposition space in which the thin film is formed on the substrate in a reduced-pressure state; a raw material gas introducing section configured to introduce a raw material gas for the thin-film into the deposition space of the deposition vessel; and a plasma electrode section configured to generate plasma using the raw material gas for the thin-film in the deposition space. The plasma electrode section is a plate member in which a current flows from one end surface to the other end surface, the plate member provided with, as a plasma generating electrode, an electrode plate including an outward portion and a return portion which allow the current to flow in parallel to each other by bending a direction of the current flowing through the plate member in mid-flow.

## Description

### Technical Field

The present invention relates to a thin-film forming apparatus that forms a thin film on a substrate using plasma.

### Background Art

Conventionally, a CVD (Chemical Vapor Deposition) device is used to form a thin film on a substrate. Particularly, a process of forming an amorphous Si thin film used for a thin film solar cell on a glass substrate using the CVD device attracts attention. For example, in the formation of the amorphous Si thin film, monosilane (SiH₄) plasma is generated to form the amorphous Si thin film on the glass substrate. Nowadays, because a thin-film solar cell panel is enlarged, there is a need to form the uniform amorphous Si thin film on the large-size panel. Therefore, in the plasma CVD device, there is a need to uniformly form high-density plasma.

A plasma generating method and a plasma generating device, in which a plurality of high-frequency antennas are disposed in a plasma generating chamber and a high-frequency power is applied to gas in the plasma generating chamber using the high-frequency antennas to generate inductively-coupled plasma, are known as an example of the plasma CVD device (Patent Literature 1).
In the plasma generating method and plasma generating device, at least some of the plurality of high-frequency antennas are disposed in parallel in such a manner that some of the plurality of high-frequency antennas are adjacent to each other sequentially while any adjacent antennas face to each other. In addition, the plurality of high-frequency antennas are disposed in parallel in such a manner that some of the plurality of high-frequency antennas are adjacent to each other sequentially while any adjacent antennas face to each other. An electron temperature in the inductively-coupled plasma is controlled by controlling a phase of a high-frequency voltage applied to each of the high-frequency antennas.

There is also known a plasma generating device including a vacuum vessel, an opening that is provided in a wall surface of the vacuum vessel, and a plate-like high-frequency antenna conductor that is attached so as to cover the opening in an airtight manner (Patent Literature 2).
Since the plasma generating device has a structure in which the high-frequency antenna conductor is attached to the opening of the plasma generating device, a highly uniform plasma can be generated in a wide range.

### Citation List

### Patent Literature

Patent Literature 1: Japanese Patent Application Laid-Open No. 2007-149639
Patent Literature 2: WO2009/142016A1

### Summary of Invention

### Technical Problem

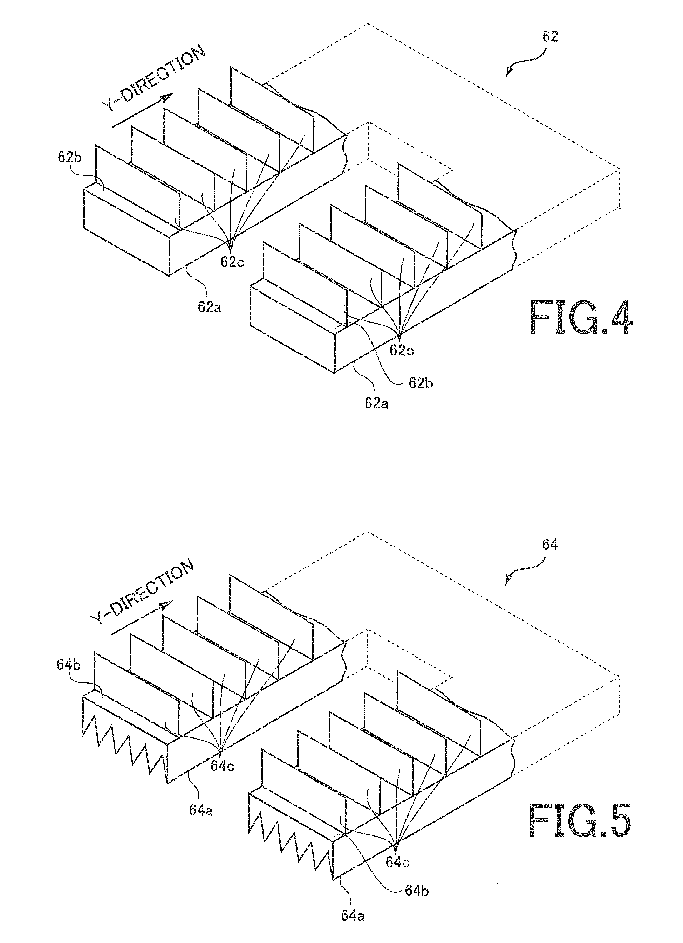

Fig. 4A is a view simply illustrating an example of a plasma deposition device in which the plate-like high-frequency antenna conductor is employed. In a plasma deposition device 100 in Fig. 4 A, an electrode plate 102 is provided in an opening of a dividing wall 106, which is located outside of a deposition chamber of a deposition vessel 104, and a dielectric body 108 is provided on a surface of the dividing wall 106 on a side facing a deposition space. A glass substrate G for forming the thin film is disposed to oppose the dielectric body 108. The glass substrate G is placed on a susceptor 112 provided on a heater 110.

Fig. 4B is a schematic perspective view of the electrode plate 102 that generates a magnetic field in the deposition space. As illustrated in Fig. 4B, the electrode plate 102 is a plate-like electrode. One of end surfaces of the electrode plate 102 is connected to a high-frequency power source of tens of megahertz, and the other end surface of the electrode plate 102 is grounded. In the electrode plate 102, a current flows in an X-direction. In a system in which the plasma is generated using the electrode plate 102, the plasma is generated using the generated magnetic field unlike the device disclosed in Patent Literature 1 that generates the plasma using a high voltage generated by the plurality of high-frequency antennas adjacent to each other.
However, unfortunately density of the plasma generated by the electrode plate 102 is not enough to form the amorphous Si thin film, and a deposition rate is low. In the known plasma generating method and plasma generating device described above for generating the inductively-coupled plasma by supplying a high-frequency power to the plurality of high-frequency antennas, there is also a problem that an enough plasma density can be obtained uniformly.

In order to solve the problem, an object of the invention is to provide a thin-film forming apparatus capable of forming the thin film efficiently by obtaining uniform plasma density when the thin film is formed on the substrate using the plasma.

### Means To Solve the Problem

An aspect of the present invention is a thin-film forming apparatus configured to form a thin film on a substrate. The thin-film forming apparatus includes:
a deposition vessel that includes a deposition space in which a thin film is formed on a substrate in a reduced-pressure state;
a raw material gas introducing section configured to introduce a raw material gas for the thin-film into the deposition space of the deposition vessel; and
a plasma electrode section configured to generate plasma using the raw material gas for the thin-film in the deposition space.
The plasma electrode section includes an electrode plate, as a plasma generating electrode, in which a current flows from one end surface to the other end surface, the electrode plate including an outward portion of the current and a return portion allowing the current to flow in parallel to each other by bending a direction of the current flowing through the electrode plate in mid-flow.

In the thin-film forming apparatus, a length of the outward portion is preferably identical to a length of the return portion of the return portion.
Preferably, the outward portion and the return portion have an identical width, and a distance between the outward portion and the return portion is 1 to 1.6 times the width of the outward portion and the return portion.
A thickness of the electrode plate is preferably greater than 0.2 mm.
A first main surface of the electrode plate is preferably disposed so as to face the deposition space, and a plurality of groove-shaped recesses extending along the direction of the current are preferably provided in the outward portion and the return portion of the first main surface.
Also preferably, a first main surface of the electrode plate is disposed so as to face the deposition space, and an irregularity extending along a direction orthogonal to the direction of the current is provided on a second main surface opposite to the first main surface. In the embodiment, the irregularity is preferably formed as a plurality of plate members that are vertically provided on the second main surface.

### Advantageous Effect of Invention

In the thin-film forming apparatus, the density of the generated plasma can be uniform and the thin film can be efficiently formed.

### Brief Description of Drawings

Fig. 1 is a schematic diagram illustrating a configuration of a thin-film forming apparatus according to an embodiment of the invention.
Fig. 2A is a perspective view illustrating an example of an electrode plate used for the thin-film forming apparatus in Fig. 1, and Fig. 2B is a perspective view illustrating an electrode plate according to a first modification different from the electrode plate illustrated in FIG. 2A.
Figs. 3A and 3B are views illustrating a relationship between the electrode plate and an electron density of a generated plasma.
Fig. 4 is a perspective view illustrating an electrode plate according to a second modification different from the electrode plate of the embodiment.
Fig. 5 is a perspective view illustrating an electrode plate according to a third modification different from the electrode plate of the embodiment.

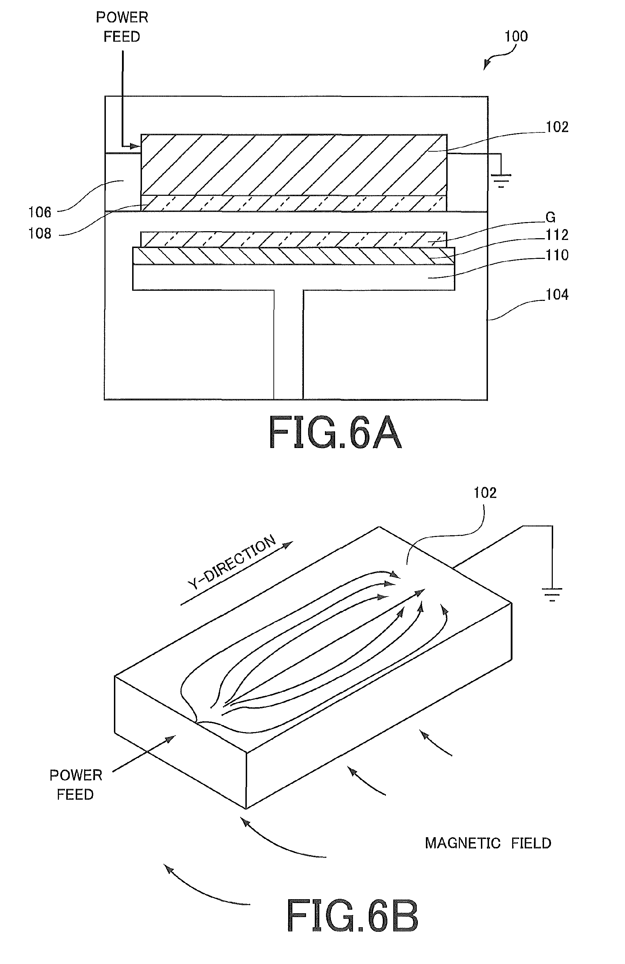

Figs. 6A and 6B are views illustrating an example of an electrode plate used for a conventional thin-film forming apparatus.

### Description of Embodiments

Hereinafter, a thin-film forming apparatus according to an embodiment of the invention will be described in detail.

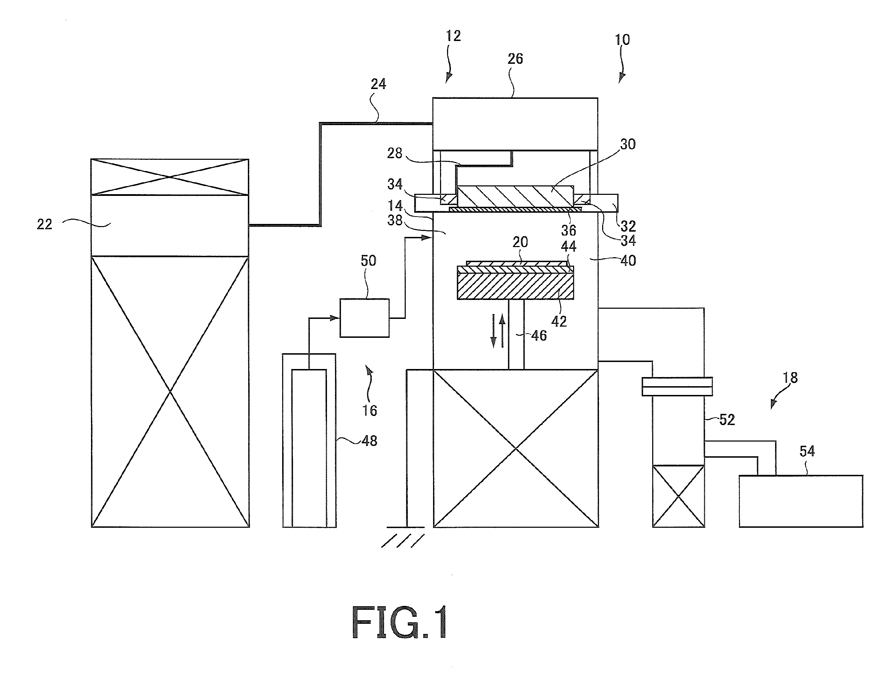

Fig. 1 is a schematic diagram illustrating a configuration of a thin-film forming apparatus 10 according to the embodiment of the invention.

The thin-film forming apparatus 10 in Fig. 1 is a CVD device that forms a thin film on a substrate using a generated plasma. The thin-film forming apparatus 10 is a system in which the plasma is generated by the magnetic field generated by the current flowing through the electrode plate. The system differs from a system in which a plasma is generated by a high voltage generated by a resonance of an antenna element and the like including a monopole antenna.

### (Thin-Film Forming Apparatus)

The thin-film forming apparatus 10 will be described below with reference to an example in which an amorphous Si thin film is formed as the thin film. The thin-film forming apparatus 10 includes a power supply unit 12, a deposition vessel 14, a gas supply section 16, and a gas discharge section 18.

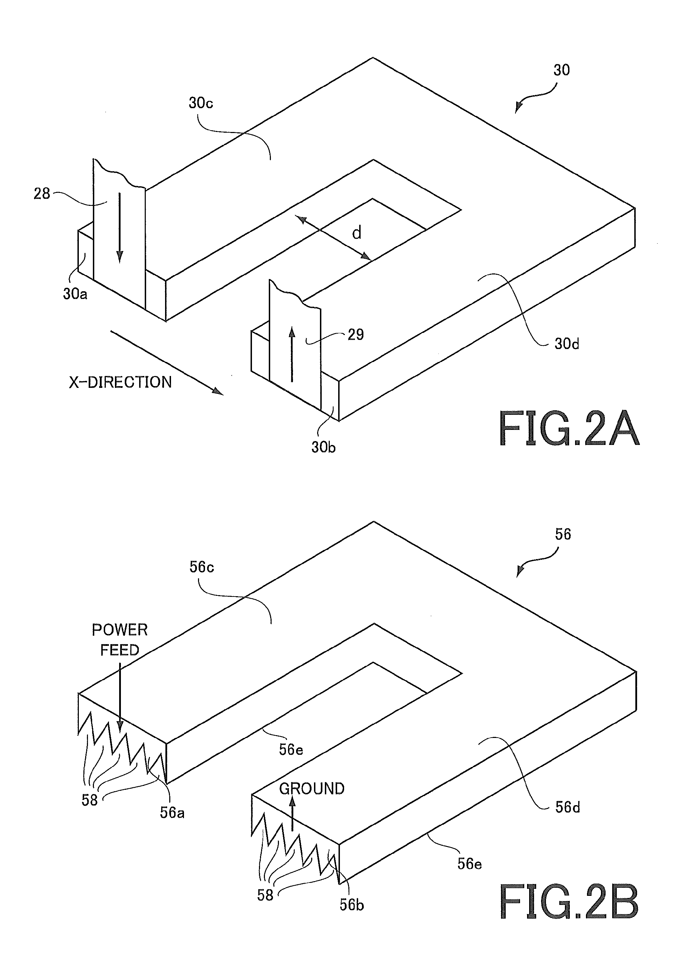

The power supply unit 12 includes a high-frequency power source 22, a high-frequency cable 24, a matching box 26, transmission lines 28 and 29 (see Fig. 2A), and an electrode plate 30.
For example, the high-frequency power source 22 supplies a high-frequency power of 10 W to 1000 W at tens of megahertz to the electrode plate 30. The matching box 26 performs an impedance matching such that the power provided through the high-frequency cable 24 is efficiently supplied to the electrode plate 30. The matching box 26 includes a known matching circuit provided with elements including a capacitor and an inductor.
For example, the transmission line 28 extending from the matching box 26 is a copper plate-like transmission line path having a constant width, and several amperes of current can flow through the electrode plate 30. The transmission line 29 extends from the electrode plate 30 and grounded.

The electrode plate 30 is a plate member that is fixed onto a dividing wall 32 to be described later, and is positioned in parallel to the dividing wall 32 while a first main surface thereof faces the deposition space in the deposition vessel 14. In the electrode plate 30, a current flows along a longitudinal direction of the plate member between an end surface connected to the transmission line 28 and an end surface connected to the transmission line 29. The electrode plate 30 is formed into a squared U-shape having a flowing direction of a current folded in mid-flow. This point is described later.

The deposition vessel 14 has an internal space 38 in the vessel, and a dividing wall 32 divides the internal space 38 into an upper space and a lower deposition space 40. The deposition vessel 14 is made of a material, such as aluminum, for example, and sealed such that the internal space 38 is put into reduced-pressure states of 0.1 Pa to 100 Pa. The deposition vessel 14 includes the matching box 26, the transmission lines 28 and 29, and the electrode plate 30 in the upper space. The electrode plate 30 is fixed onto the dividing wall 32 on the side facing the upper space. An insulating member 34 is provided around the electrode plate 30 in order to insulate the electrode plate 30 from the surrounding dividing wall 32. On the other hand, a dielectric body 36 is provided on the dividing wall 32 on the side facing the deposition space 40. The dielectric body 36 is made of a quartz plate, for example. The reason the dielectric body 36 is provided in order to prevent the corrosion of the electrode plate 30 and to supply electromagnetic energy efficiently to the plasma.

A heater 42, a susceptor 44, and a lifting and lowering mechanism 46 are provided in the deposition space 40 of the deposition vessel 14.
The heater 42 heats a glass substrate 20 placed on the susceptor 44 to a predetermined temperature, for example, about 250°C.
The glass substrate 20 is placed on the susceptor 44.
The lifting and lowering mechanism 46 lifts and lowers the susceptor 44, on which the glass substrate 20 is placed, and the heater 42 in the deposition space 40. In a deposition process stage, the glass substrate 20 is set in a predetermined position so as to come close to the electrode plate 30.

The gas supply section 16 includes a gas tank 48 and a mass flow controller 50.
A monosilane gas (SiH₄) that is a raw material gas for the thin-film is stored in the gas tank 48.
The mass flow controller 50 adjusts a flow rate of the monosilane gas. For example, the flow rate of the monosilane gas can be adjusted according to the resultant thickness or quality of the formed film. The monosilane gas is supplied into the deposition space 40 from a sidewall of the deposition space 40 of the deposition vessel 14.

The gas discharge section 18 includes a discharge pipe extending from the sidewall in the deposition space 40, a turbo-molecular pump 52, and a dry pump 54. The dry pump 54 roughly vacuums the deposition space 40, and the turbo-molecular pump 52 keeps the pressure in the deposition space 40 in a predetermined reduced-pressure state. The turbo-molecular pump 52 and the dry pump 54 are connected by the discharge pipe.

### (Electrode Plate)

Fig. 2A is a perspective view illustrating an example of the electrode plate 30 used for the power supply unit 12.
The electrode plate 30 having a U-shape is a long plate member in which the current flows from one end surface 30a to the other end surface 30b. That is, the electrode plate 30 is bent 180 degrees at a part in the longitudinal direction thereof and has an outward portion 30c and a return portion 30d, which are parallel to each other. The electrode plate 30 is used as the plasma generating electrode.
For example, the electrode plate 30 is made of copper or aluminum.

The power is fed to the end surface 30a of the outward portion 30c of the electrode plate 30 through the matching box 26 and the transmission line 28. The return portion 30d is grounded through the transmission line 29.
It is preferable that a length of the outward portion 30c, namely, the length from the end surface 30a to the bent portion be identical to a length of the return portion 30d, namely, the length from the bent portion to the end surface 30b. This is because the plasma density to be described later can be uniform.
The outward portion 30c and the return portion 30d have the identical width (a width in an X-direction in Fig. 2A). From the viewpoint of generating the uniform plasma by generating of the uniform magnetic field, it is preferable that a distance d between the outward portion 30c and the return portion 36d be 1 to 1.6 times the widths of the outward portion 30c and return portion 30d.

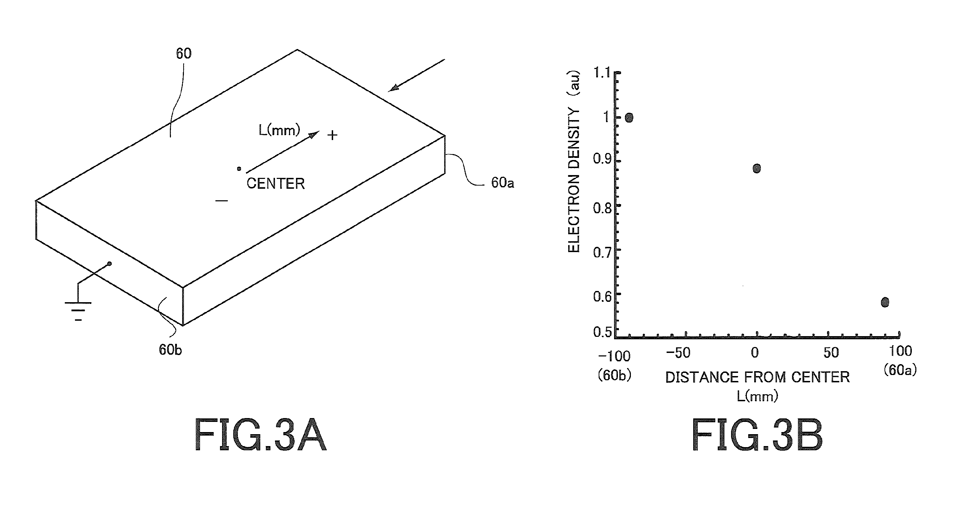

Figs. 3A and 3B are views illustrating a relationship between the electrode plate and electron density of the generated plasma.
When an electrode plate 60 in Fig. 3A is employed instead of the electrode plate 30 of the thin-film forming apparatus 10 in Fig. 1, the plasma generated in the deposition space 40 to which the monosilane gas (1.3 Pa) is introduced has the electron density as in Fig. 3B.
Unlike the electrode plate 30, the electrode plate 60 is an electrode plate that unidirectionally extends with no bent portion. Here, a high-frequency power (13.56 MHz to 60 MHz) of 1 kW is fed to the end surface 60a of the electrode plate 60, and the end surface 60b is grounded.
That is, as illustrated in Fig. 3B, the high electron density is obtained on the ground side (the side of the end surface 60b) while the low electron density is obtained on the power feed side (the side of the end surface 60a). The reason is assumed that the plasma (the plasma derived from the current), which is generated based on the magnetic field generated by the current, is dominant on the ground side while the plasma (the plasma derived from the voltage) generated by the high voltage is dominant on the power feed side. Because it is considered that electron energy is low on the power feed side due to the high voltage to hardly generate a high-density plasma.

Accordingly, the fact that the plasma density is higher on the ground side is utilized, and the squared U-shape electrode plate 30 in Fig. 2A is used to mix a region where the plasma density is low on the power supply side and a region where the plasma density is high on the ground side, thereby generating average plasma density. Additionally, because the current directions of the outward portion 30c and return portion 30d are reversed each other, the magnetic fields generated by the currents are added to each other in the portion of the distance d of the electrode plate 30. As a result, the uniform magnetic field is generated in the deposition space 40. Accordingly, using the squared U-shape electrode plate 30 in which the outward portion 30c and return portion 30d have a substantially identical length, the plasma density of the outward portion 30c and the plasma density of the return portion 30d can be averaged in the longitudinal direction to achieve the uniform plasma density.

A surface portion where the current flows throughout the electrode plate 30 depends on an electric resistivity of the electrode plate 30, a frequency of the flowing current, and permeability of the electrode plate 30. For example, when the frequency of the current is set to tens of megahertz while the electrode plate 30 is made of copper or aluminum, a depth of the surface portion is about 0.1 mm. Therefore, it is preferable that the thickness of the electrode plate 20 be greater than 0.2 mm in consideration of the currents flowing through the surface portions of the first main surface (a plate surface facing the lower side of the electrode plate 30 in Fig. 2A) 30a and second main surface (a plate surface facing the upper side of the electrode plate 30 in Fig. 2A).

### (First Modification)

Fig. 2B is a perspective view illustrating an electrode plate 56 having a configuration different from that of the electrode plate 30 in Fig. 2A.
The electrode plate 56 having a U shape is a long plate member in which the current flows from one end surface 56a to the other end surface 56b. That is, the electrode plate 56 is bent in mid-course in the longitudinal direction thereof to have an outward portion 56c and a return portion 56d, which are parallel to each other. The electrode plate 56 is employed as the plasma generating electrode.
A plurality of groove-shaped recesses 58, which extend in the current flowing direction and have constant depths and widths, are provided in a first main surface (a surface on the lower side of the electrode plate 56 in Fig. 2B) 56e in the outward portion 56c and return portion 56d of the electrode plate 56. Therefore, in the electrode plate 56, a surface area of the first main surface 56e is greater than a surface area of a second main surface (a plate surface facing the upper side of the electrode plate 56 in Fig. 2B) on the opposite side to the first main surface 56e. The high-frequency current flowing through the electrode plate 56 is concentrated on the surface portions of the first main surface 56e and second main surface due to a surface effect. However, because the surface area of the first main surface 56e is greater than that of the second main surface, the current flowing through the surface layer of the first main surface 56e is greater than that of the second main surface. Compared with an electrode plate in which the recesses 58 are not provided, the magnetic field generated in the deposition space 40 is stronger due to the current flowing through the surface portion of the first main surface 56e. Therefore, the plasma generated by the magnetic field is of high density. Additionally, because the magnetic field is generated with the electrode plate 56, the thin-film forming apparatus 10 can widely generate the uniform magnetic field, and therefore the high-density plasma can widely be generated.

### (Second Modification)

Fig. 4 is a perspective view illustrating an electrode plate 62 having a configuration different from that of the electrode plate 30 in Fig. 2A. The electrode plate 62 is formed into the U-shape like the electrode plate 30. That is, the electrode plate 62 is bent in mid-course in the longitudinal direction thereof to have an outward portion and a return portion, which are parallel to each other. The electrode plate 62 is employed as the plasma generating electrode.
A plurality of fin-shaped thin-plate members 62c, which extend in a direction orthogonal to the X-direction in which the current flows, are vertically provided at constant intervals with a constant height on the outward portion and return portion on a second main surface 62b located on the opposite side to a first main surface 62a facing the deposition space 40 of the electrode plate 62. The reason the thin-plate members 62c are provided on the side of the second main surface 62b is that a sectional area in the current flowing direction changes largely on the side of the second main surface 62b, thereby increasing a resistance. Therefore, the current easily flows through the first main surface 62a in which the resistance is less than that of the second main surface 62b. Accordingly, the current flowing through the first main surface 62a is increased, and the magnetic field formed in the deposition space 40 can be increased by the current flowing through the first main surface 62a than the conventional apparatus.
Additionally, the thin-plate members 62c are also advantageous in the point that it effectively radiates heat generated by the flow of the current through the electrode plate 62. Here, what is provided to the second main surface 62b of the electrode plate 62 is not limited to the thin-plate members 62c, but may be an irregularity extending along the direction orthogonal to the current flowing direction. On the electrode plate 62, at least an irregularity increasing the resistance of the current flowing through the surface portion of the second main surface 62b is preferably provided.

### (Third Modification)

Fig. 5 is a perspective view illustrating an electrode plate 64 having a configuration different from that of the electrode plate 56 in Fig. 2B). The electrode plate 64 is formed into the U-shape like the electrode plate 56. That is, the electrode plate 64 is bent in mid-course in the longitudinal direction thereof to have an outward portion and a return portion, which are parallel to each other. The electrode plate 64 is employed as the plasma generating electrode.
Like the recesses 58 provided in the first main surface 56e of the electrode plate 56 in Fig. 2B, a first main surface 64a of the electrode plate 64 has the plurality of groove-shaped recesses, which extend in the X-direction in which the current flows, with constant depth and height. Similarly to the first modification, the surface area of the first main surface 64a is greater than that of a second main surface 64b, and the current flowing through the surface layer of the first main surface 64a is greater than that of the second main surface 64b. On the other hand, a plurality of fin-shaped thin-plate members 64c, which extend in the direction orthogonal to the X-direction in which the current flows, are vertically provided at constant intervals with a given height on the outward portion and return portion on the second main surface 64b. Similarly to the second modification, the resistance of the second main surface 64b is increased because the sectional area in the current flowing direction is largely changed on the side of the second main surface 64b. Therefore, in addition to the effect of the surface area of the first main surface 64a, the current flows more easily through the first main surface 64a. Accordingly, the magnetic field formed in the deposition space 40 can be larger than the conventional apparatus by increasing the current flowing through the first main surface 64a.
Additionally, the thin-plate members 64c are also advantageous in the point that it effectively radiates heat generated by the flow of the current through the electrode plate 64. Here, what is provided to the second main surface 62b of the electrode plate 62 is not limited to the thin-plate members 62c, but may be an irregularity extending along the direction orthogonal to the current flowing direction. On the electrode plate 62, at least an irregularity increasing the resistance of the current flowing through the surface layer of the second main surface 62b is preferably provided.

In the first and third modifications, the depths and widths of the recesses provided in the first main surface are kept constant. Alternatively, the depths and widths of the recesses may vary depending on their locations. For example, in a portion in which the current hardly flows through the first main surface, the depths or widths of the recesses may be changed such that the surface area is enlarged for the current to easily flow.
In the second and third modifications, the heights and intervals of the fin-shaped thin-plate members are kept constant. Alternatively, the heights or intervals of the thin-plate members may vary depending on their locations. For example, in a portion in which the current hardly flows in the first main surface, the heights or intervals of the recesses may be changed such that the resistance of the current flowing through the surface portion of the second main surface is increased to increase the current through the first main surface.

As described above, in the electrode plate that is a long plate member used to generate the plasma, the current flows from one end surface to the other end surface. The electrode plate has the outward portion and the return portion allowing the current to flow in parallel to each other by bending the longitudinal direction of the current in mid-flow. Therefore, the uniform plasma density can be obtained.

Although the thin-film forming apparatus of the invention is described above in detail, the thin-film forming apparatus of the invention is not limited to the embodiment. Various changes and modifications can be made without departing from the scope of the invention.

### Reference Signs List

10 thin-film forming apparatus
12 power supply unit
14, 104 deposition vessel
16 gas supply section
18 gas discharge section
20 glass substrate
22 high-frequency power source
24 high-frequency cable
26 matching box
28, 29 transmission line
30, 56, 60, 62, 64, 102 electrode plate
30a, 30b, 56a, 56b, 60a, 60b end surface
30c, 56c outward portion
30d, 56d return portion
32, 106 dividing wall
34 insulating member
36, 108 dielectric body
38 internal space
40 deposition space
22, 110 heater
44, 112 susceptor
46 lifting and lowering mechanism
48 gas tank
50 mass flow controller
52 turbo-molecular pump
54 dry pump
58 recess
56e, 62a, 64a first main surface
62b, 64b second main surface
62c, 64c thin-plate member
100 plasma deposition device

## Claims

1. A thin-film forming apparatus configured to form a thin film on a substrate, the thin-film forming apparatus comprising:
a deposition vessel that includes a deposition space in which a thin film is formed on a substrate in a reduced-pressure state;
a raw material gas introducing section configured to introduce a raw material gas for the thin-film into the deposition space of the deposition vessel; and
a plasma electrode section configured to generate plasma using the raw material gas for the thin-film in the deposition space,
wherein the plasma electrode section includes an electrode plate, as a plasma generating electrode, in which a current flows from one end surface to the other end surface, the electrode plate including an outward portion of the current and a return portion allowing the current to flow in parallel to each other by bending a direction of the current flowing through the electrode plate in mid-flow.

2. The thin-film forming apparatus according to claim 1, wherein a length of the outward portion is identical to a length of the return portion of the return portion.

3. The thin-film forming apparatus according to claim 1 or 2, wherein
the outward portion and the return portion have an identical width, and
a distance between the outward portion and the return portion is 1 to 1.6 times the width of the outward portion and the return portion.

4. The thin-film forming apparatus according to any one of claims 1 to 3, wherein a thickness of the electrode plate is greater than 0.2 mm.

5. The thin-film forming apparatus according to any one of claims 1 to 4, wherein a first main surface of the electrode plate is disposed so as to face the deposition space, and a plurality of groove-shaped recesses extending along the direction of the current are provided in the outward portion and the return portion of the first main surface.

6. The thin-film forming apparatus according to any one of claims 1 to 5, wherein a first main surface of the electrode plate is disposed so as to face the deposition space, and an irregularity extending along a direction orthogonal to the direction of the current is provided on a second main surface opposite to the first main surface.

7. The thin-film forming apparatus according to claim 6, wherein the irregularity is formed as a plurality of plate members that are vertically provided on the second main surface.
